# EUROPEAN PATENT SPECIFICATION

(11) **EP 1 052 679 B1**
(45) Date of publication and mention of the grant of the patent: **08.11.2006**
(21) Application number: 99108986.3
(22) Date of filing: 06.05.1999
(51) Int. Cl.: H01J 37/28, H01J 37/145

(54) **Corpuscular beam device**
Korpuskularstrahlgerät
Appareil à faisceau corpusculaire

(43) Date of publication of application: 15.11.2000
(73) Proprietor: ADVANTEST CORPORATION, Shinjuku-ku, Tokyo 163-08 (JP)
(72) Inventor: Frosien, Jürgen, Dr., 85521 Riemerling (DE)
(74) Representative: Tetzner, Michael

(56) References cited:
- EP-A- 0 333 018
- EP-A- 0 762 468
- EP-A- 0 810 629

## Description

The invention relates to a corpuscular beam device with an objective lens for focussing a primary particle beam onto a specimen and a detector for detecting the secondary and/or backscattered particles released at the specimen.

High resolution objective lenses for image generation of a specimen comprise electrostatic retarding field lenses or combined electrostatic magnetic lenses. Such lenses use a higher beam energy in front of the lens and decelerate the beam to the lower final beam energy inside the objective lens. The deceleration for the primary particle beam is also used for the extraction and the acceleration of the secondary particles released at the specimen. The secondary and/or backscattered particles are transferred to detection means for registration and for forming an image of the surface of the specimen.

In high resolution lenses a high immersion ratio (Eᵢₙ : Eₒᵤₜ) is applied, since a high immersion ratio reduces the aberration of the lens, especially the spherical and the chromatic aberration. Since the retarding field is arranged in the objective lens close to the specimen, a high immersion ratio also means in conventional arrangements a strong extraction field for the secondary particles. This results in a good collection efficiency, but also generates problems when imaging insulating specimens. A strong extraction field results in a strong positive charging of the insulating surface, which makes imaging impossible or at least disrupts the imaging significantly.

To overcome this problem EP-A-0 333 018 proposes an objective lens with an additional control electrode arranged above the specimen. By applying a voltage to this control electrode, an additional field can be superimposed on the "leakage field" of the objective lens. Correspondingly, the field generated by the objective lens will be influenced and any field strength required at the specimen can be adjusted. However, if the specimen or the column is tilted, the control voltage of the control electrode causes an asymmetrical field between the specimen and the lens. This asymmetrical field affects both the primary beam (slight deflection) and the secondary beam (tilted secondary electron distribution with effects on detection efficiency).

EP-A-0 810 629 discloses an electron beam apparatus according to the preamble to claim 1. This apparatus uses two electrodes to adjust the intensity of an electric field near the secondary electron detector. The first electrode is formed by a grid mesh and is mounted on the upper pole piece of the objective lens. The second electrode having a ring form is disposed above the first electrode. The objective lens and the first and second electrodes interact with each other to cause secondary electrons to be passed through the pole piece opening of the objective lens and then drawn out toward the detector.

The object of the invention, is to improve the corpuscular beam device according to the preamble to claim 1 so that it has a high electrical field inside the objective lens, a low electrical extraction field in the region of the specimen and a high secondary and/or backscattered particle detection efficiency.

This object is achieved by the features of claim 1 and 9.

The electrode arranged above the specimen is a sieve electrode with a central hole for the primary particle beam and a plurality of additional holes for the secondary and/or backscattered particles. If the diameter of this central hole is small enough, e.g. less than 2 mm, the leakage field of the objective lens is small. By such a design surface charging can be avoided totally. Since the additional holes of the sieve electrode are also small, the extraction field can be kept small, but the detection probability using a larger number of holes can be increased significantly.

Further embodiments of the invention are the subject matter of the subordinate claims. Some embodiments of the invention and further advantages are described in the following description with reference to the drawings.

In the drawings
- Fig.1: shows a schematic representation of the corpuscular beam device according to a first embodiment,
- Fig.2: shows a top view of the sieve lens shown in Fig.1 and
- Fig.3: shows a schematic representation of the corpuscular beam device according to a second embodiment.

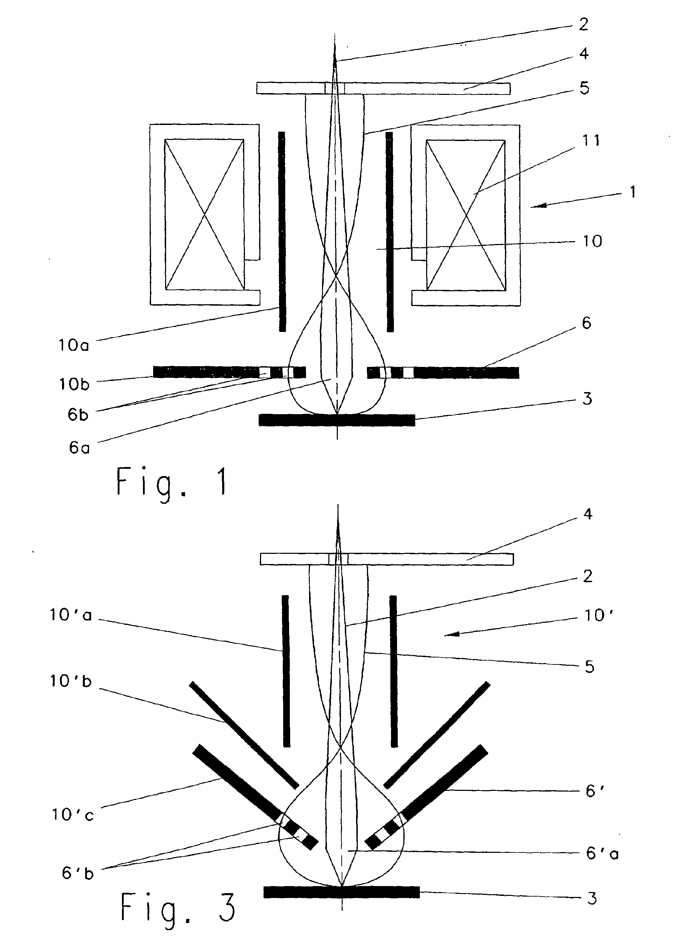

The corpuscular beam device shown in Fig.1 comprises an objective lens 1 for focussing a primary particle beam 2 onto a specimen 3 and a detector 4 for detecting secondary and/or backscattered particles 5 released at the specimen. Furthermore, there is a sieve electrode 6 which is arranged above the specimen 3. The sieve electrode has a central hole 6a for the primary particle beam 2 and a plurality of additional holes 6b for secondary and/or backscattered particles.

Preferably the primary particle beam is an electron beam which is generated by a suitable source. Furthermore the device comprises further means, e.g. condenser lens, stigmator, ..., which are known in the art and are not disclosed in the drawings.

The objective lens 1 is a combined electrostatic magnetic lens. The electrostatic lens 10 consists of a tube electrode 10a and a second electrode 10b which is formed by the sieve electrode 6.

The magnetic lens 11 can be a pole piece lens, a single pole lens in front of or behind the specimen or any other kind of magnetic lens. The electrostatic lens 10 is preferably a retarding field lens which decelerates the primary particle beam to a final low energy.

In spite of forming a part of the electrostatic lens, the sieve lens 6 may also be arranged between the objective lens 1 and the specimen 3.

The detector 4 is arranged in front of the objective lens 1. However, an in-lens detector could also be applied.

The central hole 6a of the sieve lens 6 is made so small that the leakage field of the electrostatic lens 10 is small. The diameter should be less than 2 mm, preferably less than 1 mm. By such a design, surface charging can be avoided totally, and accordingly the drawbacks of specimen tilt will also be avoided, because no additional field is created between the lens and the specimen.

The diameter of the central hole 6b may also be less than the diameter of the primary particle beam when passing through the sieve lens. In this case a double deflection scan system has to be used having the pivot point (beam tilting point) in the central hole.

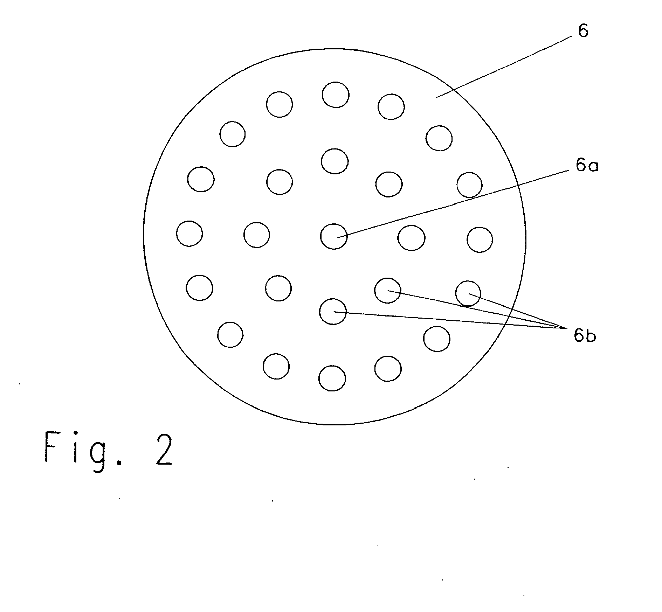

The drawback of low detection efficiency for secondary and/or backscattered particles, which is the consequence of this design, is remedied according to the invention by the arrangement of additional holes 6b in the sieve electrode. These additional holes 6b are arranged around the central hole 6a as shown in Fig.2 and are used for secondary and/or backscattered particle detection. Since the additional holes 6b of the sieve electrode are also small, the extraction field can be kept small, but the detection probability using a larger number of holes 6b can be increased significantly. Since the retarding field of the electrostatic lens 10 also leaks through the additional hole 6b, the slow secondary particles are extracted into the objective lens and transferred to the detector 4 with high efficiency.

The holes of the sieve lens are preferably round. However, the sieve lens may be also formed by a wire mesh or other arrangements with openings.

The number and size of the holes will be adapted to the requirements.

Fig.3 shows a second embodiment of a corpuscular beam device which differs from the device according to Fig.1 in that the objective lens is an electrostatic retarding lens, comprising three electrodes 10'a, 10'b, 10'c. The last electrode 10'c is formed by the sieve electrode 6' which also has a central hole 6'a for the primary particle beam and additional holes 6'b for the secondary and/or backscattered particles. The sieve electrode 6' or electrode 10'c and electrode 10'b have a conical shape which improves the passing through of the secondary particles which increases the efficiency of the detection system. Furthermore, the conical shape of the sieve electrode 6' facilitates the specimen or column tilt.

The potential of the sieve electrode 6, 6' is preferably close to or at the specimen potential to overcome the limitations when tilting the specimen or column. The embodiments disclose a high resolution corpuscular beam device having
- a high electrical field inside the objective lens for achieving low aberration coefficients,
- low electrical extraction fields in front of the specimen to avoid charging of the surface of the specimen and
- high secondary and/or backscattered particle detection efficiency in spite of this low extraction field.

## Claims

1. Corpuscular beam device with
an objective lens (1) for focussing a primary particle beam (2) onto a specimen (3),
a detector (4) for detecting secondary and/or backscattered particles (5) released at the specimen (3) and
an electrode arranged above the specimen for influencing the field generated by the objective lens, said electrode is a sieve electrode (6, 6') with a central hole (6a, 6'a) for the primary particle beam (2) and a plurality of additional holes (6b, 6'b) for the secondary and/or backscattered particles (5),
**characterised in that** the sieve electrode is arranged between the objective lens (1) and the specimen (3).

2. Device according to claim 1, **characterised in that** the objective lens (1) comprises an electrostatic retarding field lens (10, 10').

3. Device according to claim 1, **characterised in that** the sieve electrode (6, 6') can be supplied with a variable voltage.

4. Device according to claim 1, **characterised in that** the holes of the sieve electrode are round.

5. Device according to claim 1, **characterised in that** the diameter of the holes of the sieve electrode is less than 2 mm, preferably less than 1 mm.

6. Device according to claim 1, **characterised in that** the central hole is positioned in the centre of the sieve lens and the second holes are arranged around the central hole.

7. Device according to claim 1, **characterised in that** the diameter of the central hole (6a, 6'a) is less than the diameter of the primary particle beam (2) when passing through the sieve lens.

8. Device according to claim 1, **characterised in that** the sieve lens (6') has a conical shape.

9. Corpuscular beam device with
an objective lens (1) for focussing a primary particle beam (2) onto a specimen (3),
a detector (4) for detecting secondary and/or backscattered particles (5) released at the specimen (3) and
an electrode arranged above the specimen for influencing the field generated by the objective lens, said electrode is a sieve electrode (6, 6') with a central hole (6a, 6'a) for the primary particle beam (2) and a plurality of additional holes (6b, 6'b) for the secondary and/or backscattered particles (5),
**characterised in that** the objective lens comprises an electrostatic retarding field lens (10, 10') which has at least two electrodes, wherein the sieve electrode (6, 6') is formed by the last electrode in the direction of the primary particle beam (2).

## Patentansprüche

1. Korpuskularstrahlgerät mit
eine Objektivlinse (1) zum Fokussieren eines Primärteilchenstrahls (2) auf eine Probe (3),
einen Detektor (4) zum Erfassen von Sekundär- und/oder rückgestreuten Teilchen (5), die an der Probe (3) freigesetzt werden, und
eine Elektrode, die über der Probe angeordnet ist, um das von der Objektivlinse erzeugte Feld zu beeinflussen, wobei die Elektrode eine Siebelektrode (6, 6') ist, mit einem zentralen Loch (6a, 6'a) für den Primärteilchenstrahl (2) und einer Vielzahl von zusätzlichen Löchern (6b, 6'b) für die Sekundär- und/oder rückgestreuten Teilchen (5),
**dadurch gekennzeichnet, dass** die Siebelektrode zwischen der Objektivlinse (1) und der Probe (3) angeordnet ist.

2. Gerät nach Anspruch 1, **dadurch gekennzeichnet, dass** die Objektivlinse (1) eine elektrostatische Bremsfeldlinse (10, 10') umfasst.

3. Gerät nach Anspruch 1, **dadurch gekennzeichnet, dass** die Siebelektrode (6, 6') mit einer variablen Spannung versorgt werden kann.

4. Gerät nach Anspruch 1, **dadurch gekennzeichnet, dass** die Löcher der Siebelektrode rund sind.

5. Gerät nach Anspruch 1, **dadurch gekennzeichnet, dass** der Durchmesser der Löcher der Siebelektrode kleiner als 2 mm ist, vorzugsweise kleiner als 1 mm.

6. Gerät nach Anspruch 1, **dadurch gekennzeichnet, dass** das zentrale Loch in der Mitte der Sieblinse positioniert ist und die zweiten Löcher um das zentrale Loch herum angeordnet sind.

7. Gerät nach Anspruch 1, **dadurch gekennzeichnet, dass** der Durchmesser des zentralen Lochs (6a, 6'a) kleiner ist als der Durchmesser des Primärteilchenstrahls (2) bei Durchgang durch die Sieblinse.

8. Gerät nach Anspruch 1, **dadurch gekennzeichnet, dass** die Sieblinse (6') eine konische Form aufweist.

9. Korpuskularstrahlgerät mit
eine Objektivlinse (1) zum Fokussieren eines Primärteilchenstrahls (2) auf eine Probe (3),
einen Detektor (4) zum Erfassen von Sekundär- und/oder rückgestreuten Teilchen (5), die an der Probe (3) freigesetzt werden, und
eine Elektrode, die über der Probe angeordnet ist, um das von der Objektivlinse erzeugte Feld zu beeinflussen, wobei die Elektrode eine Siebelektrode (6, 6') ist, mit einem zentralen Loch (6a, 6'a) für den Primärteilchenstrahl (2) und einer Vielzahl von zusätzlichen Löchern (6b, 6'b) für die Sekundär- und/oder rückgestreuten Teilchen (5),
**dadurch gekennzeichnet, dass** die Objektivlinse (1) eine elektrostatische Bremsfeldlinse (10, 10') umfasst, die wenigstens zwei Elektroden aufweist, wobei die Siebelektrode (6, 6') durch die letzte Elektrode in der Richtung des Primärteilchenstrahls (2) gebildet wird.

## Revendications

1. Appareil à faisceau corpusculaire, avec
une lentille d'objectif (1) pour focaliser un faisceau particulaire primaire (2) sur un échantillon (3),
un détecteur (4), pour détecter les particules secondaires et/ou rétro-diffusées (5) libérées à l'échantillon (3), et
une électrode disposée au-dessus de l'échantillon pour influencer le champ généré par la lentille d'objectif, ladite électrode étant une électrode à tamis (6, 6') avec un trou central (6a, 6a') pour le faisceau particulaire primaire (2) et une série de trous supplémentaires (6b, 6b') pour les particules secondaires et/ou rétro-diffusées (5),
**caractérisé en ce que** l'électrode à tamis est disposée entre la lentille d'objectif (1) et l'échantillon (3).

2. Appareil selon la revendication 1, **caractérisé en ce que** la lentille d'objectif (1) comprend une lentille à champ de retard électrostatique (10, 10').

3. Appareil selon la revendication 1, **caractérisé en ce que** l'électrode à tamis (6, 6') peut être alimentée avec une tension variable.

4. Appareil selon la revendication 1, **caractérisé en ce que** les trous de l'électrode à tamis sont ronds.

5. Appareil selon la revendication 1, **caractérisé en ce que** le diamètre des trous de l'électrode à tamis est inférieur à 2 mm, de préférence inférieur à 1 mm.

6. Appareil selon la revendication 1, **caractérisé en ce que** le trou central est positionné au centre de la lentille à tamis et les deuxièmes trous sont disposés autour du trou central.

7. Appareil selon la revendication 1, **caractérisé en ce que** le diamètre du trou central (6a, 6a') est inférieur au diamètre du faisceau particulaire primaire (2) lorsqu'il passe dans la lentille à tamis.

8. Appareil selon la revendication 1, **caractérisé en ce que** la lentille à tamis (6') a une forme conique.

9. Appareil à faisceau corpusculaire, avec
une lentille d'objectif (1) pour focaliser un faisceau particulaire primaire (2) sur un échantillon (3),
un détecteur (4), pour détecter les particules secondaires et/ou rétro-diffusées (5) libérées à l'échantillon (3), et
une électrode disposée au-dessus de l'échantillon pour influencer le champ généré par la lentille d'objectif, ladite électrode étant une électrode à tamis (6, 6') avec un trou central (6a, 6a') pour le faisceau particulaire primaire (2) et une série de trous supplémentaires (6b, 6b') pour les particules secondaires et/ou rétro-diffusées (5),
**caractérisé en ce que** la lentille d'objectif comprend une lentille à champ de retard électrostatique (10, 10'), qui a au moins deux électrodes, où l'électrode à tamis est formée par la dernière électrode en direction du faisceau particulaire primaire (2).
